# EUROPEAN PATENT SPECIFICATION

(11) **EP 4 354 665 B1**
(45) Date of publication and mention of the grant of the patent: **11.12.2024**
(21) Application number: 22200611.6
(22) Date of filing: 10.10.2022
(51) Int. Cl.: H01R 9/24, H01R 9/26, H02B 1/052

(54) **MOUNTING SYSTEM FOR MOUNTING A TOP UNIT ONTO AN ELECTRONIC CONTROLLER MODULE**
MONTAGESYSTEM ZUR MONTAGE EINER OBEREN EINHEIT AUF EINEM ELEKTRONISCHEN STEUERMODUL
SYSTÈME DE MONTAGE POUR MONTER UNE UNITÉ SUPÉRIEURE SUR UN MODULE DE COMMANDE ÉLECTRONIQUE

(43) Date of publication of application: 17.04.2024
(73) Proprietor: Danfoss A/S, 6430 Nordborg (DK)
(72) Inventor: Hahs, Charles, 6430 Nordborg (DK); De Bona, Rossano, 6430 Nordborg (DK)
(74) Representative: Keil & Schaafhausen Patentanwälte PartGmbB

(56) References cited:
- DE-U1- 202017 104 591
- US-A- 4 581 489

## Description

The present invention relates to a mounting system for detachably fixing a top unit onto a housing of an electronic controller module mountable on a standardized equipment rail for holding electronic controller modules.

Further, the invention relates to a method of using the mounting system.

In the sense of the present invention, an electronic controller module is for example a module, which is used to control electronical components like, valves, compressors, robots, actuators etc. Further, the electronic controller module can be connected for example to sensors of any kind, such that the electronic controller module is able to control the above-described electronical components based on information provided by the sensors.

Electronic controller modules comprise housings, which protect inner components from external influences. The housings comprise cable connections and mounting means to connect components to the electronic controller module, or to mount the electronic controller modules to the rail or alike.

In order to provide control signals to electronical components, the electronic controller module comprises for example at least one processor, a data storage, a sensor input, a data input/output etc., wherein the data input/output is for example connected to electronical components and/or other electronic controller modules and the sensor input is connected to sensors. The sensor input can be integrated in a data input/output. The data storage comprises a data program, which can be used to determine control information to the electronical components by using information provided by the sensors for example.

The electronic controller module can be mounted on a standardized equipment rail, for example a DIN-rail or a top hat rail IEC/EN 60715. Such a standardized equipment rail is typically mounted on a wall in a horizontal manner, allowing mounting of electronic controller modules, power units, IO-units or alike.

A top unit in the sense of the present invention is a unit, which covers a part of a top side of the electronic controller module in a detachably manner. The top side of the electronic controller module is a side of the controller module, which faces away from the standardized equipment rail. An example of such a controller module is disclosed by the document DE202017104591, Wago Verwaltungs GMBH, published on 6 November 2018.

Electronic controller modules should be maintained or serviced over their lifetimes within certain time periods, or after events like failures and breakdowns. Thus, service persons need to be able to interact with the electronic controller modules. To do so, the service persons can detach any of the data input/output connections such that this connection can be used to communicate with the electronic controller module. However, such a disconnection raises several problems; e.g. the disconnected component cannot be serviced during this time. Furthermore, an additional device like a computer is needed to communicate with the electronic controller module via a network cable or alike, which is connected to a data input/output of the electronic controller module.

Therefore, the present invention shall provide a solution for an easy mounting of a top unit onto an electronic controller module.

This problem is solved by a mounting system according to claim 1 for detachably fixing a top unit onto a housing of an electronic controller module mountable on a standardized equipment rail for holding electronic controller modules. Preferred embodiments are disclosed in the dependent claims.

The mounting system comprises a mechanical engagement mechanism for pivotable mechanical engagement of the top unit with the electronic controller module, and a magnetic retaining mechanism for releasably retaining the top unit in a swiveled-in position.

To mount the top unit onto the electronic controller module (controller module), the top unit is attached to controller module, such that a primary end section of the top unit comes into contact with the controller module. The primary end section of the top unit and the controller module can interact mechanically with each other. A mechanical engagement between the controller module and the top unit occurs, allowing the top unit to be swiveled (tilted) relative to the controller module while being in mechanical engagement with the controller module.

Afterwards, the top unit is tilted or pivoted, e.g. (at least substantially) about the primary end section, such that the remaining portion of the top unit approaches the controller module. In other words, the top unit can then be brought into the swiveled-in position. Within a certain distance, the magnetic retaining mechanism, provided on the top unit and the controller module, attracts the respective other part, such that the magnetic retaining mechanism retains the top unit onto the controller module.

The mechanical engagement mechanism prevents detaching the top unit from the controller module while the top unit is in the swiveled-in position.

For detaching the top unit, a retaining force provided by the magnetic retaining mechanism has to be overcome first. This allows to swivel the top unit out of the swiveled-in position, e.g. to a swiveled-out position.

In more detail, by overcoming the retaining force provided by the magnetic retaining mechanism in the course of detachment, the top unit can be tilted , e.g. (at least substantially) around the primary end section such that the parts of the magnetic retaining mechanism provided on the top unit and the controller module become distanced from each other in such a way (e.g. far enough away from each other) that the magnetic retaining mechanism does not provide considerable retaining force in this state any more.

Then, e.g. in the swiveled-out position, additionally the mechanical engagement mechanism can be released, and the top unit can be completely taken off from the controller module.

This allows an easy installment of the top unit to the controller module as well as easy detachment without the need of additional tools or alike. Once being attached and in the swiveled-in position, the top unit is securely retained to the controller module, while neither in an installing or dismounting process further handling tasks like pressing a button or alike is needed.

Especially, one top unit can be mounted on different electronic controller modules consecutively, allowing a good flexibility. In particular, the same top unit can be mounted to and used with several controller modules, consecutively. This eliminates the need for providing individual top units for maintenance, service, adjustment, and/or the like for each controller module.

In a preferred embodiment, the mechanical engagement mechanism allows to swivel the top unit between the swiveled-out position and the swiveled-in position, wherein the top unit is attachable to and detachable from the controller module in the swiveled-out position and wherein the mechanical engagement mechanism retains the top unit when the top unit is in the swiveled-in position. In the swiveled-out position, the top unit can be either taken of the controller module, or tilted into the swiveled-in position, in which the top unit is retained to the controller module. So solely a tilting, pivoting, or swiveling movement of the top unit is required to "fasten" the top unit to the electronic controller module. Therefore, the handling of the top unit is very easy. The mechanical engagement mechanism is configured such that the top unit cannot be detached while the top unit is in the swiveled-in position. The top unit can only be detached when it is not in swiveled-in position. However, the top unit can be detached when it is in the swiveled-out position. Especially, the mounting system can be configured such that the mechanical engagement provided by the mechanical engagement mechanism can only be released when the top unit is in the swiveled-out position. The swiveled-out position applies when the top unit is swiveled-out from the swiveled-in position by at least a certain swivel angle.

In a preferred embodiment, the controller module comprises a first attraction means of the magnetic retaining mechanism and the top unit comprises a second attraction means of the magnetic retaining mechanism, wherein, when the top unit is in the swiveled-in position, the first attraction means and the second attraction means attract each other magnetically for releasably retaining the top unit in the swiveled-in position. In the swiveled-in position, the attraction means of the top unit interact with the attraction means of the controller module means, such that the attraction means of the top unit are attracted to the attraction means of the controller module, and the other way around. Due to the resulting retaining force, the top unit may lie firmly flat against the controller module. However, the retaining force can be overcome for swiveling out the top unit, e.g. by a user. In the swiveled-out position, an attraction between the attraction means of the top unit and the controller module is negligible, such that the top unit can be taken off (completely detached) easily. This allows an easy handling of the top unit.

In a preferred embodiment, at least one of the first attraction means and the second attraction means includes a magnet, wherein the other one of the first attraction means and the second attraction means includes a (further) magnet and/or a ferromagnet. The term ferromagnet is to be understood to comprise also materials including ferromagnets or alike, for example plastics including ferromagnetic particles or alike. A force of attraction between the first attraction means and the second attraction can be adjusted by placing the attraction means closer or farther apart (when the top unit is in the swiveled-in position).

In a preferred embodiment, the mechanical engagement mechanism comprises a first hinge means formed on the controller module and a second hinge means formed on the top unit for engaging the first hinge means. In the swiveled-in position, the first and second hinge means can be hitched, hooked, engaged to each other. In a swiveled-out position the first and second hinge interact in a detachable manner, wherein the top unit can be either attached, taken off, or transferred into the swiveled in position. Thus, the first and second hinge means are arranged accordingly to allow a tilting or swiveling movement of the top unit, in particular between the swiveled-out position and the swiveled-in position, when the top unit is engaged with the controller module via the first and second hinge means.

In a preferred embodiment, one of the first hinge means and the second hinge means comprises (at least) a hinge accommodation, and the other one of the first hinge means and the second hinge means comprises (at least) a hinge protrusion for engaging the hinge accommodation. The hinge protrusion may be securely accommodated in the hinge accommodation in the swiveled-in position. In the swiveled-out position, the hinge protrusion may be provided close to or partly within the hinge accommodation, such that the hinge protrusion can be inserted into the hinge accommodation by transferring the top unit from the swiveled-out position into the swiveled-in position. According to another aspect, the hinge accommodation allows inserting and pulling out the hinge protrusion (only) while the top unit being in the swiveled-out position.

In one embodiment, the first and second hinge means each comprise both a hinge accommodation and a hinge protrusion, wherein the hinge protrusions are securely accommodated in the corresponding other hinge accommodation in the swiveled-in position.

In a preferred embodiment, along a first direction of the top unit, the second hinge means is located at the primary end section of the top unit and the second attraction means is located on a secondary end section of the top unit distanced to the primary end section. The first direction may correspond to a longitudinal direction of the top unit, wherein the longitudinal direction of the top unit can correspond to an extension direction of the rail in the swiveled-in position. A middle section may be arranged between the primary end section and the secondary end section. Since the first hinge means are located distanced to the first attraction means, wherein a swivel motion is performed around the first hinge means located at the primary end section, there is a leverage between the first hinge means and the attraction means, such that the top unit is securely but releasably retained in the swiveled-in position.

In a preferred embodiment, the controller module comprises a first contact arrangement for electrically connecting, when the top unit is in the swiveled-in position, a second contact arrangement formed on the top unit, wherein at least one of the first contact arrangement and the second contact arrangement comprises resilient contacts. The resilient contacts can be spring biased contacts. They can be configured to travel a certain distance when a force is applied, for example. The resilient contacts allow a good electrical connection between the contact arrangements of the top unit and the controller module. The mounting system may be configured to allow data transfer and/or power transfer between the top unit and the controller module, especially via the first contact arrangement and the second contact arrangement when the top unit is in the swiveled-in position. Further, the electronic controller module may be adapted to be operated and/or controlled via the top unit, for example. This allows that the top unit can be used as control device, or alike. If the top unit comprises a memory, the mounting system may be adapted such that data can be transferred from the top unit to the controller module and/or vice versa, e.g. via the first contact arrangement and the second contact arrangement (especially when the top unit is mounted in the swiveled-in position).

In a preferred embodiment, the first contact arrangement is disposed closer to the first hinge means than to the first attraction means and the second contact arrangement is disposed closer to the second hinge means than to the second attraction means. Thus, a magnetic force applied by the magnetic retaining mechanism applies to the contact arrangement by a leveraged force, wherein a lever axle may be defined by the first and second hinge means. The arrangement of the first and second attraction means is adapted to each other. This allows a good electronic connection of the top unit and the controller mount. Especially, the second contact arrangement may be pressed against the first contact arrangement with the increased, leveraged force when the top unit is swiveled into the swiveled-in position during mounting on the controller module. The resilient contacts may be partly pushed in. The resulting resilient counterforce and the leveraged force acting between the first and second contact arrangements ensure a particularly reliable connection between the first and second contact arrangements, even if the top unit is mounted and demounted a plurality of times.

According to a further aspect, the mounting system can be configured such that the first contact arrangement and the second contact arrangement slide against each other at least during a part of the swiveling movement. Even if a sliding distance is short, this can ensure that the contact arrangements clean themselves free during the swiveling movement.

In a preferred embodiment, the top unit comprises a processor, a memory, a user input device, and/or a display. Furthermore, the top unit can comprise additional electronical elements, for example a battery element, LEDs, and/or a speaker. A service personal can interact with the electronic controller module via the top unit, while the top unit is provided in a swiveled-in position. The service personal can use the user input device, for example a touch screen, physical buttons, or alike to navigate within a in the top unit displayed software environment to control the controller module, amend its settings or alike. Further, the top unit can be used as data storage to transfer data, e.g. to
- transfer data from a first electronic controller module to a second electronic controller module,
- transfer data to several controller modules, to which the top unit is consecutively mounted, e.g. for updating the controller modules and/or for transferring new instructions to them, and/or
- transfer recoded data recorded by the controller module(s) from the controller module(s) to the top unit.

This allows an easy communication to different controllers and an easy data transfer.

In a preferred embodiment, the mounting system is arranged at a first side of the top unit, and the display is arranged at a second side of the top unit, wherein the first side and the second side are arranged opposing to each other. The second side faces in a swiveled-in position the rail, whereas the display points away from the rail in a swiveled-in position. Thus, the service personal can easily read the display.

In a preferred embodiment, the user input device is arranged next to the display. In this arrangement, the user input device is arranged at the same side as the display, such that the service personal can easily interact with the user input device.

The controller modules may be automation controller system module. It may be configured to form part of an automation controller system. In particular, it may be an automation controller system module for/of an automation controller system for controlling climate systems, air condition systems, refrigeration systems, and/or industrial installations, for example production facilities. For example, the controller module may be configured for control in systems for food retail.

In one embodiment, the mounting system includes a further controller module according to any one of the embodiments described, wherein the top unit can be used with the controller module and the further controller module consecutively.

Further, the above problem is solved by a method according to claim 13. The methods includes using a mounting system according to any one of the preceding claims. The modifications and advantages described with regard to the mounting system apply to the method accordingly, and vice versa.

The method comprises the following steps for mounting the top unit onto the controller module comprises: First, a mechanical engagement mechanism of the top unit and the electric controller module are engaged in the swiveled-out position. Second, the top unit is swiveled into the swiveled-in position, wherein the magnetic retaining mechanism retains the top unit in the swiveled-in position in a releasable manner.

This method can be done manually, only by hands, without any additional tools or pressing buttons or alike. Thus, mounting the top unit onto the controller module is easy.

In order to remove the top unit from the controller module, the top unit is transferred from the swiveled-in position to the swiveled-out position, wherein the magnetic retaining mechanism exhibits no significant retaining force when the top unit is in the swiveled-out position. Thus, the top unit can be taken off easily.

In the following, the present application is described in a preferred embodiment with reference to the drawing. Herein showing:
- Fig. 1: A perspective view of a standardized equipment rail having several electronic controller modules mounted;
- Fig. 2: A perspective view of an electronic controller module with a top unit mounted thereon;
- Fig. 3: a perspective view on a second side (a top side) of the top unit with a display and buttons;
- Fig. 4: a view on a lateral side of the top unit;
- Fig. 5: a view on an end side of the top unit in a longitudinal direction of the top unit;
- Fig. 6: a first side (an underside) of the top unit for abutting on the controller module;
- Fig. 7: a cross-sectional view of the top unit mounted on the electronical controller module; and
- Fig. 8: a cross-sectional view of the top unit at the electronical controller module in a swiveled-out position.

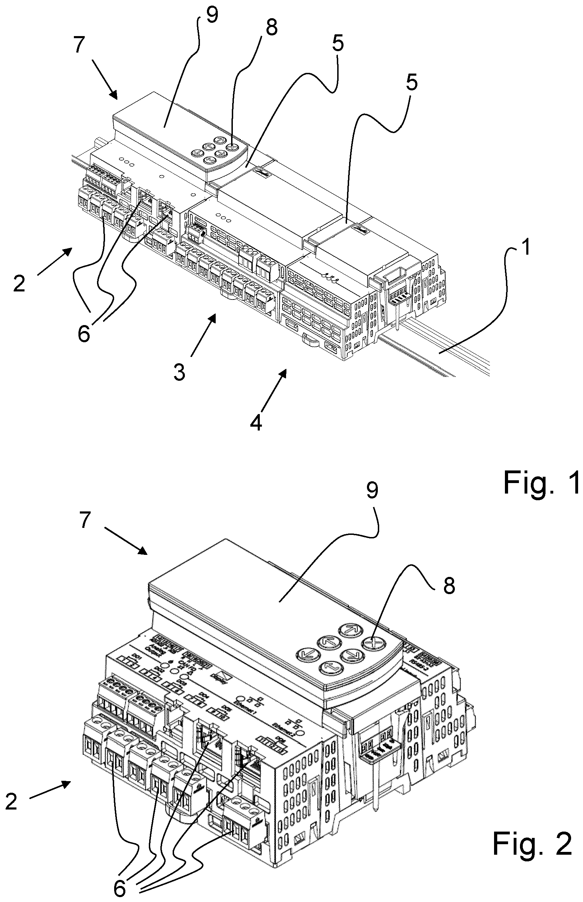

Fig. 1 shows a standardized equipment rail 1, wherein an electronic controller module 2, a first auxiliary electronic module 3, and a second auxiliary electronic module 4 are arranged on the rail 1. The rail 1 is usually mounted on a not shown wall and/or within a controller cabinet. The electronic controller module 2 and the auxiliary electronic modules 3,4 are connect to the adjacent ones via connectors 5. The first auxiliary electronic module 3 may be an input/output module (I/O-module), which is able to control a non-depicted actuator, a compressor, or alike. The second auxiliary electronic module 4 is, for example, a power supply for supplying power to the electronic controller module 2 and/or to the first auxiliary electronic module 3. The electronic controller module 2, the first auxiliary electronic module 3, and the second auxiliary electronic module 4 constitute an electronic controller module assembly, wherein the electronic controller module 2 includes the main intelligence for controlling and uses as well as controls the first auxiliary electronic module 3 and the second auxiliary electronic module 4. Hence, in functional terms, the electronic controller module assembly can be regarded as one controller module.

The electronic controller module 2 and the first auxiliary electronic module 3 comprise several cable connections 6 for connecting ethernet cables or braids of other cables or alike.

A top unit 7 is mounted on the electronic controller module 2, wherein the top unit 7 is mounted on a top side of the electronic controller module 2. Fig. 1 shows the arrangement of the top unit 7 and the electronic controller module 2 with the top unit 7 being in a swiveled-in position (and hence completely mounted). The top side of the electronic controller module 2 faces away from the rail 1. Accordingly, in the swiveled-in position, a top face of the top unit 7 faces away from the rail 1. The top side of the top unit 7 may be also referred to as its second side. The top unit 7 comprises, on its top side, a user input device. In this example, the input device includes six buttons 8. Next to the buttons 8, a display 9 is arranged on the top side of the top unit 7.

Fig. 2 depicts the electronic controller module 2 having the top unit 7 mounted on in the swiveled-in position in more detail. The electronic controller module 2 comprises several cable connections 6, which are provided on opposite lateral sides of the electronic controller module 2 perpendicular to its top side. In other words, cable connections 6 are also provided on a lateral side of the electronic controller module 2 that cannot be seen in Fig. 2.

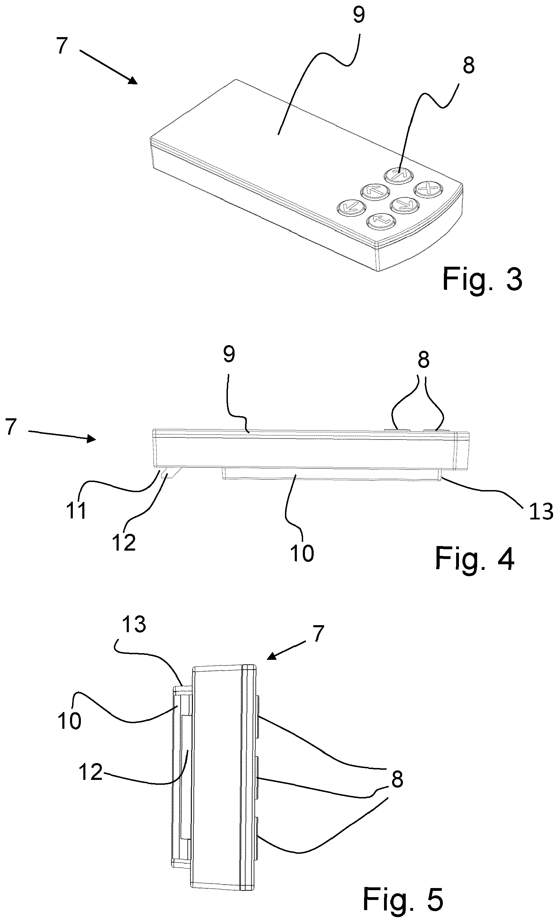

Fig. 3 shows the top unit 7 alone in a non-mounted state. The top unit 7 comprises the display 9 on its top side, wherein the top side also comprises the six buttons 8. Four of the buttons 8 are configured to navigate through a software environment provided on the top unit 7, one button 8 is a confirm button 8 to confirm a choice and one button 8 is configured to cancel choices and/or return to a previous page.

Fig. 4 shows a view on a lateral side surface of the of top unit 7. The lateral side surface is at least substantially perpendicular to the top side of the top unit 7 and extends parallel to a longitudinal direction (a first direction) of the top unit 7. On the top side, the display 9 and buttons 8 are provided, while on an underside opposite to the top side, a (second) hinge means 11, 12 and a top unit protrusion 10 are provided. The second hinge means 11, 12 comprises a hinge accommodation 11 and a hinge protrusion 12. The second hinge means 11, 12 is provided on a primary end section of the top unit 7 in the longitudinal direction (of the top unit 7). The top unit protrusion 10 is arranged at a secondary end section of the top unit 7 in said longitudinal direction. Between the primary and secondary end section of the top unit 7, a middle section is provided.

The underside of the top unit 7 may be also referred to as its first side.

The top unit protrusion 10 comprises tapered side walls 13. Hence, the projection 10 becomes narrower with increasing distance from the display 9.

The tapered walls 13 are also shown in Fig. 5, which is a view on an end side of the top unit 7 in the longitudinal direction of the latter.

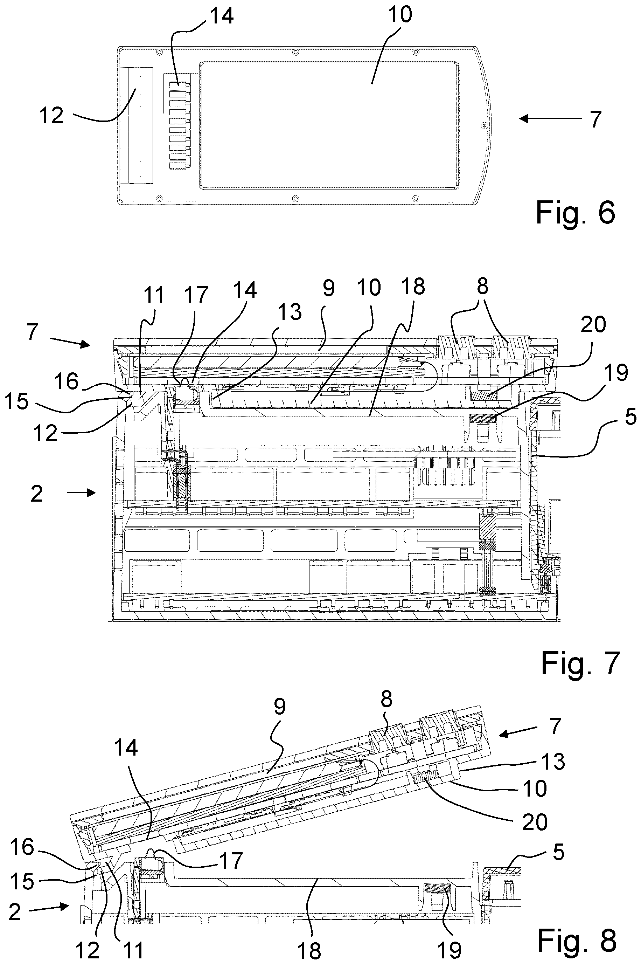

Fig. 6 shows the underside of the top unit 7. The underside may be also referred to a first side of the top unit 7. It is opposite to the top side (the first side) of the top unit 7.

The top unit 7 comprises a (second) contact arrangement 14. The second contact arrangement formed on the underside. The second contact arrangement consists of multiple contacts, in this embodiment ten contacts. Further, the contact arrangement 14 is arranged between the hinge means and the top unit protrusion 10. In other words, it is located in the middle section.

Fig. 7 depicts a sectional view of the electronic controller module 2 mounted on the rail 1, wherein the top unit 7 is in the swiveled-in position. The top unit 7 is completely mounted on the electronic controller module 2. Accordingly, it is releasably retained to the electronic controller 2 and electrically connected to the electronic controller module 2.

The electronic controller module 2 comprises a hinge means which corresponds to the hinge means 11, 12 of the top unit 7. The hinge means of the electronic controller module 2, a first hinge means 15, 16, comprise a first hinge accommodation 15 and a first hinge protrusion 16. As explained above, the hinge means of the top unit 7, the second hinge means 11, 12, comprises the second hinge accommodation 11 and the second hinge protrusion 12. The first and the second hinge means form together a mechanical engagement mechanism. The mechanical engagement allows to disengage the first hinge means 15, 16 and the second hinge means 11, 12 when the top unit 7 is swiveled out from the swiveled-in position by at least a certain swivel angle. Accordingly, the mechanical engagement allows to bring the first hinge means 15, 16 and the second hinge means 11, 12 into engagement when the top unit 7 is inclined with respect to the swiveled-in position by at least the certain swivel angle.

In the swiveled-in position, the (second) contact arrangement 14 of the top unit 7 is in contact with a first contact arrangement 17 of the electronic controller module 2. The first contact arrangement 17 comprises resilient contacts. The resilient contacts are biased, such that these contacts flex under force. In this embodiment, the resilient contacts can be urged in a direction towards the rail 1.

Further, the electronic controller module 2 comprises a first attraction means 19, namely a first magnet, which is provided distanced to the first contact arrangement 17. The first attraction means 19 interact with second attraction means 20 of the top unit 7. In this embodiment, the second attraction means 20 are formed as a second magnet. The first attraction means 19 and the second attraction means second magnet are arranged in such a way, such that the first and second magnets interact with each other when the top unit 7 is in a swiveled-in position. In more detail, they exhibit a magnetic retaining force acting against swiveling the top unit out of the swiveled-in position. The first attraction means 19, respectively the first magnet, and the second attraction means 20, namely the second magnet, together form a magnetic retaining mechanism, which retains the top unit 7 in the swiveled-in position.

The attraction means 19, 20 are distanced to each respective hinge means 11, 12; 15, 16, wherein the contact arrangements 14, 17 are arranged closer to the respective hinge means 11, 12; 15, 16 than to the attraction means 19, 20.

In this embodiment, the retaining force acts in a direction perpendicular to the top side of the electronic controller module 2 when the top unit 7 is in its swiveled-in position.

The mounting system includes an additional guiding mechanism for guiding the top unit 7 into a predetermined end position when the top unit 7 is being swiveled into the swiveled-in position. Additionally or alternatively, the guiding mechanism is adapted to secure the top unit 7, when the top unit 7 is in the swiveled-in position, in the end position relative to the electronic controller module 2 against movements perpendicular to the direction into which the retaining force acts when the top unit 7 is in the swiveled-in position.

In the swiveled-in position, the top unit protrusion 10 is accommodated in an indentation 18 of the electronic controller module 2. The indentation 18 is adapted to the top unit protrusion 10, such that the top unit 7 is at least partly secured to the electronic controller module 2 by form-fit in the swivel-in position. Therefore, the indentation 18 comprises also tapered walls, which correspond to the taper of the walls 13 of the top unit protrusion 10. In this embodiment, the indentation 18 and the top unit protrusion 10 constitute the additional guiding mechanism.

The top unit 7 comprises further a not depicted processor and a not depicted memory respectively data storage. The top unit 7 can be taken off the electronic controller module 2 and be placed on another, not depicted, electronic controller module 2. Thus, a service person can service several electronic controller modules 2 using solely one top unit 7 according to the present application.

In order to take the top unit 7 of the electronic controller module 2, the service person grabs the top unit 7 at the second end section, respectively in the area of the buttons 8 and gently pulls the top unit 7 away from the rail 1 respectively from the electronic controller module 2. A pulling force has to exceed the retaining force provided by the magnetic retaining mechanism. Subsequently, the top unit 7 will tilt around the first and second hinge means provided at the primary end section. As soon as the hinge means of the top unit 7 and the electronic controller module 2 are sufficiently disengaged, i.e. when the unit 7 has reached the swiveled-out position, the top unit 7 can be taken off the electronic controller module 2.

Fig. 8 schematically shows the top unit 7 in the swiveled-out position.

To mount the top unit 7 onto the electronic controller module 2 again or to another electronic controller module, the hinge means of the top unit 7 and the electronic controller means 2, respectively the first hinge protrusion 16 and the second hinge accommodation 11, and the second hinge protrusion 12 and the first hinge accommodation 15, are brought together, such that the hinge means can interact with each other. In a subsequent step, the top unit 7 is tilted, such that the top unit protrusion 10 is received by the indentation 18. The magnetic retaining mechanism, respectively the first and the second magnets, attract each other and form a detachable retaining of the top unit 7 onto the electronic controller module 2.

A top unit 7 can also be a not depicted cover, which covers the contacts 17 of the electronic controller module 2. Such a cover is only a cover without any electronics, displays or alike. The cover is mounted and disassembled in the same way, as described above.

An electronic controller module 2 according to the present invention can be coupled to any top unit 7 having the above-described mechanical engagement mechanism and magnetic retaining mechanism, such that a top unit 7 can be replaced by another top unit 7. Therefore, the service person has to carry just one top unit 7 while maintaining several electronic controller modules 2.

### List of reference signs:

- 1: rail
- 2: electronic controller module
- 3: electronic module
- 4: electronic module
- 5: connector
- 6: cable connector
- 7: top unit
- 8: button
- 9: display
- 10: top unit protrusion
- 11: second hinge accommodation
- 12: second hinge protrusion
- 13: protrusion wall
- 14: second contact arrangement
- 15: first hinge accommodation
- 16: first hinge protrusion
- 17: first contact arrangement
- 18: indentation
- 19: first attraction means
- 20: second attraction means

## Claims

1. Mounting system for detachably fixing a top unit (7) onto a housing of an electronic controller module (2) mountable on a standardized equipment rail (1) for holding electronic controller modules (2, 3, 4), the mounting system comprising:
a mechanical engagement mechanism (11, 12, 15, 16) for pivotable mechanical engagement of the top unit (7) with the electronic controller module (2), and
a magnetic retaining mechanism (19, 20) for releasably retaining the top unit (7) in a swiveled-in position.

2. Mounting system according to claim 1, **characterized in that** the mechanical engagement mechanism (11, 12, 15, 16) allows to swivel the top unit (7) between a swiveled-out position and the swiveled-in position, wherein the top unit (7) is attachable to and detachable from the electronic controller module (2) in the swiveled-out position and wherein the mechanical engagement mechanism (11, 12, 15, 16) retains the top unit (7) when the top unit (7) is in the swiveled-in position.

3. Mounting system according to claim 1 or 2, **characterized in that**
- the electronic controller module (2) comprises a first attraction means (19) of the magnetic retaining mechanism and that
- the top unit (7) comprises a second attraction (20) means of the magnetic retaining mechanism,
wherein, when the top unit (7) is in the swiveled-in position, the first attraction means (19) and the second attraction means (20) attract each other magnetically for releasably retaining the top unit (7) in the swiveled-in position.

4. Mounting system according to claim 3, **characterized in that** at least one of the first attraction means (19) and the second attraction means (20) includes a magnet, wherein the other one of the first attraction means (19) the second attraction means (20) includes a magnet (19, 20) and/or a ferromagnet.

5. Mounting system according to any one of claims 1 to 4, **characterized in that** the mechanical engagement mechanism (11, 12, 15, 16) comprises
- a first hinge means (15, 16) formed on the electronic controller module (2) and
- a second hinge means (11, 12) formed on the top unit (7) for engaging the first hinge means (15, 16).

6. Mounting system according to claim 5, **characterized in**
- **that** one of the first hinge means (15, 16) and the second hinge means (11, 12) comprises a hinge accommodation (11, 15), and
- **that** the other one of the first hinge means (15, 16) and the second hinge means (11, 12) comprises a hinge protrusion (12, 16) for engaging the hinge accommodation (11, 15).

7. Mounting system according to claim 5 or 6, **characterized in that**, along a first direction of the top unit (7), the second hinge means (11, 12) is located at a primary end section of the top unit (7) and that the second attraction means (20) is located on a secondary end section of the top unit (7) distanced to the primary end section.

8. Mounting system according to any one of claims 1 to 7, **characterized in that** the electronic controller module (2) comprises a first contact arrangement (17) for electrically connecting, when the top unit (7) is in the swiveled-in position, a second contact arrangement (14) formed on the top unit (7), wherein at least one of the first contact arrangement (17) and the second contact arrangement (14) comprises resilient contacts.

9. Mounting system according to claim 8, **characterized in that** the first contact arrangement (17) is disposed closer to the first hinge means (15, 16) than to the first attraction means (19) and the second contact arrangement (14) is disposed closer to the second hinge means (11, 12) than to the second attraction means (20).

10. Mounting system according to claim 8 or 9, **characterized in that** the top unit (7) comprises a processor, a memory, a user input device (8), and/or a display (9).

11. Mounting system according to claim 9 or 10, **characterized in that** the mounting system is arranged at a first side of the top unit (7), and the display (9) is arranged at an opposite, second side of the top unit (7).

12. Mounting system according to claim 10 or 11, **characterized in that** the user input (8) device is arranged next to the display (9).

13. Method for using a mounting system according to any one of claim 1 to 12, **characterized in that** the method comprises the following steps for mounting the top unit (7) onto the electronic controller module (2):
a.) a mechanical engagement mechanism of the top unit (7) and the electronic controller module (2) are engaged in a swiveled-out position,
b) the top unit (7) is swiveled into a swiveled-in position, wherein the magnetic retaining mechanism (19, 20) retains the top unit (7) in a swiveled-in position in a releasably manner.

## Patentansprüche

1. Montagesystem zum abnehmbaren Befestigen einer oberen Einheit (7) auf einem Gehäuse eines elektronischen Steuermoduls (2), das auf einer genormten Geräteschiene (1) zum Halten von elektronischen Steuermodulen (2, 3, 4) montierbar ist, wobei das Montagesystem Folgendes umfasst:
einen mechanischen Eingriffsmechanismus (11, 12, 15, 16) für einen drehbaren mechanischen Eingriff der oberen Einheit (7) mit dem elektronischen Steuermodul (2), und
einen magnetischen Rückhaltemechanismus (19, 20) zum lösbaren Zurückhalten der oberen Einheit (7) in einer eingeschwenkten Position.

2. Montagesystem nach Anspruch 1, **dadurch gekennzeichnet, dass** der mechanische Eingriffsmechanismus (11, 12, 15, 16) ein Schwenken der oberen Einheit (7) zwischen einer ausgeschwenkten Position und der eingeschwenkten Position ermöglicht, wobei die obere Einheit (7) in der ausgeschwenkten Position an dem elektronischen Steuermodul (2) anbringbar und davon abnehmbar ist und wobei der mechanische Eingriffsmechanismus (11, 12, 15, 16) die obere Einheit (7) zurückhält, wenn sich die obere Einheit (7) in der eingeschwenkten Position befindet.

3. Montagesystem nach Anspruch 1 oder 2, **dadurch gekennzeichnet, dass**
- das elektronische Steuermodul (2) ein erstes Anziehungsmittel (19) des magnetischen Rückhaltemechanismus umfasst und dass
- die obere Einheit (7) ein zweites Anziehungs(20)-Mittel des magnetischen Rückhaltemechanismus umfasst,
wobei, wenn sich die obere Einheit (7) in der eingeschwenkten Position befindet, das erste Anziehungsmittel (19) und das zweite Anziehungsmittel (20) zum lösbaren Zurückhalten der oberen Einheit (7) in der eingeschwenkten Position gegenseitig magnetisch anziehen.

4. Montagesystem nach Anspruch 3, **dadurch gekennzeichnet, dass** mindestens eines des ersten Anziehungsmittels (19) und des zweiten Anziehungsmittels (20) einen Magneten umfasst, wobei das andere des ersten Anziehungsmittels (19), des zweiten Anziehungsmittels (20) einen Magneten (19, 20) und/oder einen Ferromagneten umfasst.

5. Montagesystem nach einem der Ansprüche 1 bis 4, **dadurch gekennzeichnet, dass** der mechanische Eingriffsmechanismus (11, 12, 15, 16) Folgendes umfasst
- ein erstes Scharniermittel (15, 16), das auf dem elektronischen Steuermodul (2) ausgebildet ist, und
- ein zweites Scharniermittel (11, 12), das auf der oberen Einheit (7) zum Eingreifen in das erste Scharniermittel (15, 16) ausgebildet ist.

6. Montagesystem nach Anspruch 5, **dadurch gekennzeichnet,**
- **dass** eines des ersten Scharniermittels (15, 16) und des zweiten Scharniermittels (11, 12) eine Scharnieraufnahme (11, 15) umfasst, und
- **dass** das andere des ersten Scharniermittels (15, 16) und des zweiten Scharniermittels (11, 12) einen Scharniervorsprung (12, 16) zum Eingreifen in die Scharnieraufnahme (11, 15) umfasst.

7. Montagesystem nach Anspruch 5 oder 6, **dadurch gekennzeichnet, dass**, entlang einer ersten Richtung der oberen Einheit (7), sich das zweite Scharniermittel (11, 12) an einem primären Endabschnitt der oberen Einheit (7) befindet und dass sich das zweite Anziehungsmittel (20) auf einem sekundären Endabschnitt der oberen Einheit (7) befindet, der von dem primären Endabschnitt beabstandet ist.

8. Montagesystem nach einem der Ansprüche 1 bis 7, **dadurch gekennzeichnet, dass** das elektronische Steuermodul (2) eine erste Kontaktanordnung (17) zum elektrischen Verbinden, wenn sich die obere Einheit (7) in der eingeschwenkten Position befindet, eine zweite Kontaktanordnung (14), die auf der oberen Einheit (7) ausgebildet ist, umfasst, wobei mindestens eine der ersten Kontaktanordnung (17) und der zweiten Kontaktanordnung (14) elastische Kontakte umfasst.

9. Montagesystem nach Anspruch 8, **dadurch gekennzeichnet, dass** die erste Kontaktanordnung (17) näher an dem ersten Scharniermittel (15, 16) als an dem ersten Anziehungsmittel (19) angeordnet ist und die zweite Kontaktanordnung (14) näher an dem zweiten Scharniermittel (11, 12) als an dem zweiten Anziehungsmittel (20) angeordnet ist.

10. Montagesystem nach Anspruch 8 oder 9, **dadurch gekennzeichnet, dass** die obere Einheit (7) einen Prozessor, einen Speicher, eine Benutzereingabevorrichtung (8) und/oder eine Anzeige (9) umfasst.

11. Montagesystem nach Anspruch 9 oder 10, **dadurch gekennzeichnet, dass** das Montagesystem auf einer ersten Seite der oberen Einheit (7) angeordnet ist, und die Anzeige (9) auf einer entgegengesetzten, zweiten Seite der oberen Einheit (7) angeordnet ist.

12. Montagesystem nach Anspruch 10 oder 11, **dadurch gekennzeichnet, dass** die Benutzereingabe(8)-Vorrichtung neben der Anzeige (9) angeordnet ist.

13. Verfahren zum Verwenden eines Montagesystems nach einem der Ansprüche 1 bis 12, **dadurch gekennzeichnet, dass** das Verfahren die folgenden Schritte zum Montieren der oberen Einheit (7) auf dem elektronischen Steuermodul (2) umfasst:
a.) ein mechanischer Eingriffsmechanismus der oberen Einheit (7) und das elektronische Steuermodul (2) werden in einer ausgeschwenkten Position in Eingriff gebracht,
b) die obere Einheit (7) wird in eine eingeschwenkte Position geschwenkt, wobei der magnetische Rückhaltemechanismus (19, 20) die obere Einheit (7) in einer eingeschwenkten Position auf lösbare Weise zurückhält.

## Revendications

1. Système de montage pour fixer amovible une unité supérieure (7) sur un boîtier d'un module de commande électronique (2) pouvant être monté sur un rail d'équipement normalisé (1) pour le maintien de modules de commande électronique (2, 3, 4), le système de montage comprenant :
un mécanisme d'engagement mécanique (11, 12, 15, 16) permettant l'engagement mécanique pivotant de l'unité supérieure (7) dans le module de commande électronique (2), et
un mécanisme de retenue magnétique (19, 20) permettant de retenir amovible l'unité supérieure (7) dans une position pivotée vers l'intérieur.

2. Système de montage selon la revendication 1, **caractérisé en ce que** le mécanisme d'engagement mécanique (11, 12, 15, 16) permet de faire pivoter l'unité supérieure (7) entre une position pivotée vers l'extérieur et une position pivotée vers l'intérieur, l'unité supérieure (7) pouvant être fixée au module de commande électronique (2) et en être séparée dans la position pivotée vers l'extérieur, et le mécanisme d'engagement mécanique (11, 12, 15, 16) retenant l'unité supérieure (7) lorsque l'unité supérieure (7) est dans la position pivotée vers l'intérieur.

3. Système de montage selon la revendication 1 ou 2, **caractérisé en ce que** :
- le module de commande électronique (2) comprend un premier moyen d'attraction (19) du mécanisme de retenue magnétique, et **en ce que** :
- l'unité supérieure (7) comprend un second moyen d'attraction (20) du mécanisme de retenue magnétique,
lorsque l'unité supérieure (7) est dans la position pivotée vers l'intérieur, le premier moyen d'attraction (19) et le second moyen d'attraction (20) s'attirant mutuellement par magnétisme pour retenir amovible l'unité supérieure (7) dans la position pivotée vers l'intérieur.

4. Système de montage selon la revendication 3, **caractérisé en ce qu'**au moins un moyen parmi le premier moyen d'attraction (19) et le second moyen d'attraction (20) comprend un aimant, l'autre moyen parmi le premier moyen d'attraction (19) et le second moyen d'attraction (20) comprenant un aimant (19, 20) et/ou un ferro-aimant.

5. Système de montage selon l'une quelconque des revendications 1 à 4, **caractérisé en ce que** le mécanisme d'engagement mécanique (11, 12, 15, 16) comprend :
- un premier moyen d'articulation (15, 16) formé sur le module de commande électronique (2), et
- un second moyen d'articulation (11, 12) formé sur l'unité supérieure (7) pour s'engager dans le premier moyen d'articulation (15, 16).

6. Système de montage selon la revendication 5, **caractérisé en ce que** :
- un moyen parmi le premier moyen d'articulation (15, 16) et le second moyen d'articulation (11, 12) comprend un logement d'articulation (11, 15), et
- l'autre moyen parmi le premier moyen d'articulation (15, 16) et le second moyen d'articulation (11, 12) comprend une protubérance d'articulation (12, 16) pour s'engager dans le logement d'articulation (11, 15).

7. Système de montage selon la revendication 5 ou 6, **caractérisé en ce que**, le long d'une première direction de l'unité supérieure (7), le second moyen d'articulation (11, 12) est situé au niveau d'une section d'extrémité principale de l'unité supérieure (7), et **en ce que** le second moyen d'attraction (20) est situé sur une section d'extrémité secondaire de l'unité supérieure (7) distante de la section d'extrémité principale.

8. Système de montage selon l'une quelconque des revendications 1 à 7, **caractérisé en ce que** le module de commande électronique (2) comprend un premier agencement de contacts (17) pour connecter électriquement, lorsque l'unité supérieure (7) est dans la position pivotée vers l'intérieur, un second agencement de contacts (14) formé sur l'unité supérieure (7), le premier agencement de contacts (17) et/ou le second agencement de contacts (14) comprenant des contacts élastiques.

9. Système de montage selon la revendication 8, **caractérisé en ce que** le premier agencement de contacts (17) est disposé plus près du premier moyen d'articulation (15, 16) que du premier moyen d'attraction (19) et le second agencement de contacts (14) est disposé plus près du second moyen d'articulation (11, 12) que du second moyen d'attraction (20).

10. Système de montage selon la revendication 8 ou 9, **caractérisé en ce que** l'unité supérieure (7) comprend un processeur, une mémoire, un dispositif d'entrée d'utilisateur (8) et/ou une unité d'affichage (9).

11. Système de montage selon la revendication 9 ou 10, le système de montage étant **caractérisé en ce qu'**il est agencé au niveau d'un premier côté de l'unité supérieure (7), et **en ce que** l'écran (9) est agencé au niveau d'un second côté opposé de l'unité supérieure (7) .

12. Système de montage selon la revendication 10 ou 11, **caractérisé en ce que** le dispositif d'entrée d'utilisateur (8) est agencé à côté de l'unité d'affichage (9).

13. Procédé d'utilisation d'un système de montage selon l'une quelconque des revendications 1 à 12, le procédé étant **caractérisé en ce qu'**il comprend les étapes suivantes de montage de l'unité supérieure (7) sur le module de commande électronique (2) :
a) un mécanisme d'engagement mécanique de l'unité supérieure (7) et le module de commande électronique (2) sont engagés dans une position pivotée vers l'extérieur,
b) l'unité supérieure (7) est pivotée dans une position pivotée vers l'intérieur, le mécanisme de retenue magnétique (19, 20) retenant amovible l'unité supérieure (7) dans une position pivotée vers l'intérieur.
